Europäisches Patentamt

European Patent Office

Office européen des brevets

(11) Publication number: **0 139 308**
**B1**

# EUROPEAN PATENT SPECIFICATION

(45) Date of publication of patent specification: **18.04.90**

(51) Int. Cl.⁵: **G 01 R 33/42**

(21) Application number: **84200779.1**

(22) Date of filing: **30.05.84**

(54) **Nuclear magnetic resonance apparatus.**

(30) Priority: **14.10.83 NL 8303535**

(43) Date of publication of application:
**02.05.85 Bulletin 85/18**

(45) Publication of the grant of the patent:
**18.04.90 Bulletin 90/16**

(84) Designated Contracting States:
**CH DE FR GB LI NL**

(56) References cited:
**EP-A-0 067 933**
**DE-A-2 951 018**
**FR-A-2 114 063**
**US-A-2 864 963**

**ELECTRO/78 Conference Record, May 23-25, 1978, BOSTON (US), pages 30/2: 1-15, CING-MING LAI et al.: "Nuclear magnetic resonance zeugmatography for medical imaging".**

**COMPUTERTOMOGRAPHIE, vol. 1, 1981, STUTTGART (DE), pages 2-10, A. GANSSE et al.: "Kernspintomographie".**

(73) Proprietor: **N.V. Philips' Gloeilampenfabrieken**
**Groenewoudseweg 1**
**NL-5621 BA Eindhoven (NL)**

(72) Inventor: **Zijlstra, Hinne c/o INT.**
**OCTROOIBUREAU B.V.**
**Prof. Holstlaan 6**
**NL-5656 AA Eindhoven (NL)**

(74) Representative: **Scheele, Edial François et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a magnetic resonance imaging tomography apparatus comprising an electro-magnetic coil system having a defined axis, including a main coil for generating a steady magnetic field in an examination space enclosed by said main coil and a shield for preventing stray fields being produced outside the system, arranged coaxially about the system.

An apparatus of this kind is known from Computertomographie 1 (1981), pages 2—10. Comparatively strong stray fields occur outside the magnet in such apparatus. These stray fields occur outside the magnet in such apparatus. These stray fields are extensively dealt with in an article in Diagnostic Imaging, April 1983, pages 32—35; it is mentioned therein that such stray fields do not occur in a magnet system which is composed of permanent magnets. The drawbacks of such a magnet system are also mentioned in this article. The drawback of external stray fields is not only that they are so strong, notably in the case of nuclear magnetic resonance tomography apparatus, that they have a disturbing effect on equipment outside the magnet, but also that the measurement field in the magnet is liable to be disturbed by external variations in the stray field, for example, by displacement of large pieces of magnetic material therein. As regards nuclear magnetic resonance apparatus comprising superconducting magnets such as notably used for diagnostic nuclear magnetic resonance apparatus, it is to be noted that the magnet field and hence also the stray field are always present. For a more detailed description of superconducting magnets for notably diagnostic nuclear magnetic resonance tomography apparatus and medical nuclear magnetic resonance spectroscopy apparatus, reference is made to the chapter "Superconductivity", pages 116—127, of the book "Nuclear Magnetic Resonance Imaging", by C. L. Partain et al, W. B. Saunders Company, 1983; this type of imaging will be referred to hereinafter as MR imaging.

For adequate shielding of the external stray field of magnets comprising electromagnetic coils for generating a high field intensity in a comparatively large space as is the case in diagnostic magnetic resonance examinations, the use of a yoke corresponding to the frame of the permanent magnet described in "Diagnostic Imaging" requires a large amount of soft magnetic material.

It is the object of the invention to provide a magnetic resonance imaging apparatus which comprises an electromagnetic coil system for generating a homogeneous magnetic field and in which the external magnetic stray field is strongly reduced. To this end, a magnetic resonance imaging apparatus of the kind set forth in accordance with the invention is characterized in that said main coil is made of super conducting coils and in that said shield generating a magnetic field for compensating the stray fields said shield further comprising first and second shielding coils disposed around respective axial ends of said system, whereby said shielding coils and said super conducting coils are accommodated in a Dewar vessel.

Because the external magnetic stray field is reduced in a nuclear magnetic resonance apparatus in accordance with the invention, the disturbing effects thereof no longer occur. This substantially simplifies the steps to be taken for the operation and installation of the apparatus. Also avoided are possible adverse effects on the homogeneity of the magnetic field in the measuring space introduced by external influencing of the stray field which could occur in known apparatus. It is an advantage of this shield that the field of the coil system is also compensated for in the axial direction.

It is remarked that shielded magnetic systems per se are known from EP 67 933 in which document an electromagnetic coil system for NMR Tomography is disclosed provided with a cylindrical main coil (1) provided with correcting coils (2 and 3) and a cylinder (4) of soft magnetic material mounted about the coil system for shielding. The coils 2 and 3 undoubtly have the function of correcting coils and not a shielding function. They act as is stated to homogenize the steady magnetic field in a measuring room inside the magnet system just as the soft magnetic cylinder can be shaped for optimalisation of the homogeneity of said measuring field. A coil pair according to the invention can also be used in conjunction with a shield consisting of a soft magnetic material. An optimum division of tasks between the two shields can then be achieved, so that on the one hand a smaller amount of magnetic material suffices whilst on the other hand the current intensity through the shielding coils can be reduced. An attractive combination can be realized by accommodating the magnetic shielding sleeve as well as the shielding coils in a Dewar vessel which is to be filled with helium. The shielding coils can again be constructed so that they are optimally excited by the stray field of the actual magnet.

It is remarked that a shielded magnet system kept on a low temperature per se is known from DE—A—2.951.018. Aim of this system is to realise a measuring magnetic field which has a high homogeneity in time and space such that measurings with the very sensitive squid system (8) can be made. The system therefore is kept on a liquid helium temperature of about 4 K and the magnetic coils have ellipsoidal shape in order to avoid disturbances from outside the magnet onto the measuring field which action is enforced by the use of a double magnet system, which contrary to the present system has no openings for objects to be examined such as patients.

Some preferred embodiments in accordance with the invention will be described in detail hereinafter with reference to the drawing. Therein:

Figure 1 shows a magnet system in accordance with the invention of such an apparatus shielded by means of a Helmholtz-like coil pair and,

Figure 2 shows an embodiment in which a shielded coil system and an additional shielding are accommodated in a Dewar vessel.

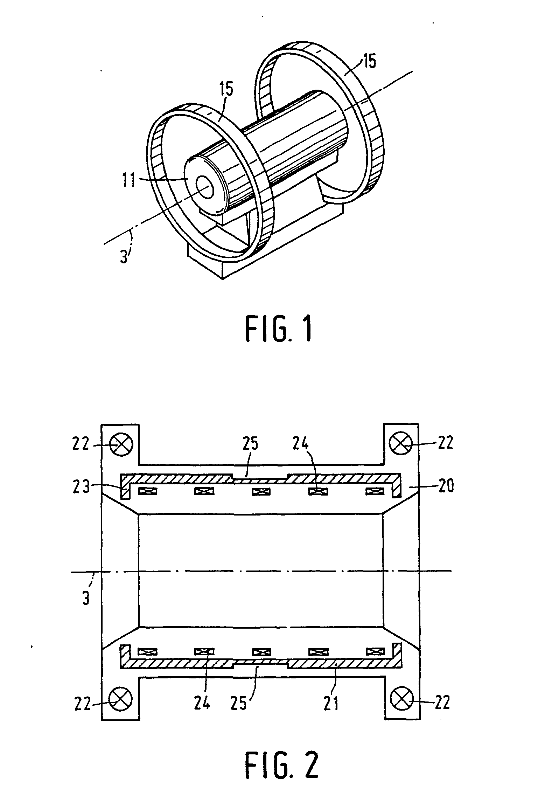

Figure 1 shows an embodiment in which the shielding is realised by a coil pair 15. Active shielding is now achieved by a compensating field of the coils. An advantage of this shield is that the axial stray field of the magnet is strongly reduced. By choosing a suitable configuration of the wire windings, the energy required for the shielding coils can be reduced. The energy consumption is reduced by constructing the shielding coils as superconductive carrying persistent currents. To this end, each of the coils may be accommodated in an adapted helium Dewar vessel and may be designed for excitation by a flux pump. Alternatively, the shielding coils may be composed of hollow, current carrying wires of superconducting material wherethrough liquid helium is pumped for cooling. By choosing a suitable geometry, it can be achieved that the already superconducting shielding coils are excited to the correct value for shielding by induction from the measurement magnet. This is because the coils will then opposed the enclosed flux and compensate for this flux by a corresponding counter-flux.

Figure 2 shows an embodiment of a magnet comprising a shielding sleeve 21 which is accommodated in a helium Dewar vessel 20 and shielding coils 22 which are also accommodated in a Dewar vessel. The shielding sleeve may comprise end portions 23 which additionally force the magnetic field inwards. At the area of the superconducting windings 24 of the actual magnet coil, the magnet field is comparatively small in this construction so that, as has already been stated, the persistent currents may be larger, the intensity of the magnetic field can be increased, and the Lorentz forces on the windings are smaller. By forming recesses 25 in the sleeve, the shielding effect can be optimized and hence also the field in the measurement space in respect of local homogeneity of the field In the sleeve, a premagnetization can be formed by means of permanent magnetic material. Even though the combination of a shielding sleeve and shielding coils has been described, one of the two shields can also be separately used.

## Claims

1. A magnetic resonance imaging tomography apparatus comprising an electro-magnetic coil system having a defined axis, including a main coil (11) for generating a steady magnetic field in an examination space enclosed by said main coil (11) and a shield for preventing stray fields being produced outside the system, arranged coaxially about the system, characterized in that said main coil (11) is made of super conducting coils and in that said shield generating a magnetic field for compensating the stray fields said shield further comprising first and second shielding coils (15) disposed around respective axial ends of said system, whereby said shielding coils (15) and said super conducting coils are accommodated in a Dewar vessel.

2. A magnetic resonance imaging tomography apparatus as claimed in Claim 1, characterized in that between the two shielding coils (15) there is arranged an additional shielding (21) composed as a passive magnetic shielding.

3. A magnetic resonance imaging tomography apparatus as claimed in Claim 2, characterized in that said additional shielding (21) comprises means (25) for optimizing the local homogeneity at the steady magnetic field in the measurement space.

## Patentansprüche

1. Kernspinresonanz-Abbildungstomographieapparat mit einem Elektromagnetspulensystem mit einer bestimmten Achse, das eine hauptspule (11) zum Erzeugen eines statischen Magnetfelds in einem von der Hauptspule (11) umschlossenen Untersuchungsraum und einen koaxial um das System angebrachten Schirm zum Abwehren von außerhalb des Systems erzeugten Streufeldern enthält, dadurch gekennzeichnet, daß die Hauptspule (11) aus supraleitenden Spulen besteht, das Abwehrschirm zum Ausgleichen der Streufelder ein Magnetfeld erzeugt und dazu um die betreffenden axialen Enden des Systems angeordnete erste und zweite Abschirmspulen (15) enthält, und diese Abschirmspulen (15) und die supraleitenden Spulen in einem Dewar-Gefäß angeordnet sind.

2. Kernspinresonanz-Abbildungstomographieapparat nach Anspruch 1, dadurch gekennzeichnet, daß zwischen den beiden Abschirmspulen (15) eine zusätzliche Abschirmung (21) angebracht ist, die als passive Magnetabschirmung zusammengesetzt ist.

3. Kernspinresonanz-Abbildungstomographieapparat nach Anspruch 2, dadurch gekennzeichnet, daß die zusätzliche Abschirmung (21) Mittel (25) zum Optimieren der örtlichen Homogenität des statischen Magnetfelds im Meßraum enthält.

## Revendications

1. Appareil de tomographie pour imagerie par résonance magnétique nucléaire comprenant un système de bobines électromagnétiques présentant un axe défini comprenant une bobine principale (11) destinée à générer un champ magnétique constant dans un espace d'examen enfermé par la bobine principale (11) et un blindage pour empêcher des champs parasites d'être produits en dehors du système, disposé coaxialement autour du système, caractérisé en ce que la bobine principale (11) est faite d'enroulements supraconducteurs et en ce que le blindage génère un champ magnétique pour compenser les champs parasites, ce blindage comprenant, en outre, une première et une seconde bobine de blindage (15) disposées autour des extrémités axiales respectives du système, les bobines de blindage (15) et les bobines supraconductrices étant logées dans une vase de Dewar.

2. Appareil de tomographie pour imagerie par résonance magnétique nucléaire suivant la revendication 1, caractérisé en ce qu'entre les deux bobines de blindage (15) est disposé un blindage supplémentaire (21) ayant la forme d'un blindage magnétique passif.

3. Appareil de tomographie pour imagerie par résonance magnétique nucléaire suivant la revendication 2, caractérisé en ce que le blindage supplémentaire (21) comprend un moyen (25) pour optimiser l'homogénéité locale du champ magnétique constant dans l'espace de mesure.

FIG. 1

FIG. 2